# EUROPEAN PATENT APPLICATION

(11) **EP 2 426 735 A1**
(43) Date of publication of application: **07.03.2012**
(21) Application number: 11179278.4
(22) Date of filing: 30.08.2011
(51) Int. Cl.: H01L 31/05

(54) **Conductive adhesive member and solar cell module**

(30) Priority: 02.09.2010 JP 2010196960
(71) Applicant: Nitto Denko Corporation, Osaka 567-8680 (JP)
(72) Inventor: Yamazaki, Hiroshi, Osaka, 567-8680 (JP); Buzoujima, Yasushi, Osaka, 567-8680 (JP); Daigaku, Noritsugu, Osaka, 567-8680 (JP)
(74) Representative: HOFFMANN EITLE

(57) **Abstract**

A conductive adhesive member (1) includes a conductive region (2) continuously exposed along one direction, and an adhesive region (3) exposed along the conductive region (2).

## Description

### BACKGROUND OF THE INVENTION

### Field of the Invention

The present invention relates to a conductive adhesive member and a solar cell module, and particularly to a conductive adhesive member used appropriately as a collector electrode and a solar cell module including the conductive adhesive member.

### Description of the Related Art

Conventionally, for connection between the connection terminals of various electric equipment, a conductive adhesive member having both conductivity and adhesiveness, such as a conductive adhesive tape, has been used.

For example, an adhesive tape showing conductivity has been proposed which has a conductive lining material formed with projections, and an adhesive layer covering a surface of the conductive lining material (see, for example, Japanese Examined Patent Publication No. Sho 47-51798).

In the adhesive tape proposed in Japanese Examined Patent Publication No. Sho 47-51798, the adhesive layer over the surfaces of the projections is formed to have a thickness which causes dielectric breakdown therein, and the adhesive layer is bonded to a base material. When a current flows in the base material, dielectric breakdown occurs in the adhesive layer to cause conduction between the base material and the conductive lining material via the adhesive layer.

### SUMMARY OF THE INVENTION

In recent years, a conductive adhesive tape has been required to have more excellent conductivity. However, the adhesive tape proposed in Japanese Examined Patent Publication No. Sho 47-51798 has the problem of insufficient conductivity when the adhesive tape is used since the adhesive layer is interposed between the conductive lining material and the base material.

In addition, a conductive adhesive tape is also required to have excellent durability which allows the conductivity to be maintained over a long period.

An object of the present invention is to provide a conductive adhesive member and a solar cell module each having excellent conductivity and durability.

A conductive adhesive member of the present invention includes a conductive region continuously exposed along one direction, and an adhesive region exposed along the conductive region.

In the conductive adhesive member of the present invention, it is preferable that the adhesive region is disposed on each of both sides of the conductive region.

In the conductive adhesive member of the present invention, it is preferable that the conductive region includes a plurality of stripe portions.

It is preferable that the conductive adhesive member of the present invention further includes a conductive portion including a recessed portion, and an adhesive portion filling in the recessed portion, wherein the adhesive region is the adhesive portion, and the conductive region is the conductive portion exposed from the adhesive portion.

In the conductive adhesive member of the present invention, it is preferable that the conductive region includes a low-melting-point metal layer formed on a surface thereof.

It is preferable that the conductive adhesive member of the present invention is used as a collector electrode for collecting carriers generated in a solar cell.

A solar cell module of the present invention includes a solar cell, and a conductive adhesive member used as a collector electrode for collecting carriers generated in the solar cell, wherein the conductive adhesive member includes a conductive region continuously exposed along one direction, and an adhesive region exposed along the conductive region.

In the conductive adhesive member of the present invention, the conductive region is exposed, and therefore can be reliably brought into contact with an adherend. In addition, the conductive adhesive member is continuously exposed along the one direction, and therefore it is possible to ensure a sufficient contact area between the conductive region and the adherend.

In addition, the adhesive region is exposed along the conductive region. Therefore, by being bonded to the adherend, the adhesive region can reliably bring the conductive region into contact with the adherend, and can also maintain the state of contact therebetween over a long period.

When the adhesive region is bonded to the adherend, the conductive region and the adherend are in direction contact with each other. Therefore, it is possible to prevent the adhesive region from entering into the gap between the conductive region and the adherend.

As a result, it is possible to ensure excellent conductivity between the conductive region and the adherend, and ensure excellent durability which allows the conductivity to be maintained over a long period. Therefore, the conductive adhesive member of the present invention has excellent conductivity and durability.

By using the conductive adhesive member of the present invention as a collector electrode, carriers generated in the solar cell can be reliably collected, and the solar cell module including the solar cell and the conductive adhesive member has excellent power generation efficiency.

### BRIEF DESCRIPTION OF THE DRAWINGS

FIG. 1 shows a perspective view of a conductive adhesive tape as an embodiment of a conductive adhesive member of the present invention;
FIG. 2 is a process step view for illustrating a method of producing the conductive adhesive tape shown in FIG. 1,
   ,
   (a) showing the step of preparing a conductive plate,
   (b) showing the step of forming low-melting-point metal layers,
   (c) showing the step of bending the conductive plate, and
   (d) showing the step of forming adhesive portions;
FIG. 3 shows a perspective view illustrating the step of bending the conductive plate of FIG. 2(c);
FIG. 4 shows a perspective view illustrating the step of forming the adhesive portions of FIG. 2(d);
FIG. 5 shows a perspective view of an embodiment (a form in which photoelectric conversion portions are amorphous-silicon-based) of a solar cell module of the present invention;
FIG. 6 shows an enlarged perspective view illustrating a connection structure between terminals and collector electrodes (left-hand portion);
FIG. 7 shows a side cross-sectional view of the connection structure of FIG. 6;
FIG. 8 shows a front cross-sectional view of the connection structure of FIG. 6;
FIG. 9 shows a perspective view of a conductive adhesive tape (a form in which low-melting-point metal layers are not formed) as another embodiment of the conductive adhesive member of the present invention;
FIG. 10 shows a perspective view of a conductive adhesive tape (a form in which a conductive portion is formed in a generally meandering cross-sectional shape) as still another embodiment of the conductive adhesive member of the present invention;
FIG. 11 shows a perspective view of a conductive adhesive tape (a form in which a conductive portion is formed in a generally comblike cross-sectional shape) as yet another embodiment of the conductive adhesive member of the present invention;
FIG. 12 is a process step view for illustrating a method of producing the conductive adhesive tape shown in FIG. 11,
   ,
   (a) showing the step of preparing a conductive sheet,
   (b) showing the step of forming an etching resist,
   (c) showing the step of half-etching the conductive sheet, and
   (d) showing the step of filling with adhesive portions;
FIG. 13 is a process step view for illustrating a method of producing the conductive adhesive tape shown in FIG. 11,
   ,
   (a) showing the step of preparing a conductive sheet,
   (b) showing the step of forming a plating resist,
   (c) showing the step of forming projecting portions, and
   (d) showing the step of filling with adhesive portions;
FIG. 14 shows a perspective view of a conductive adhesive tape (a form in which a conductive portion includes conductive wires each having a generally ellipsoidal cross-sectional shape) as still another embodiment of the conductive adhesive member of the present invention;
FIG. 15 is a process step view for illustrating a method of producing the conductive adhesive tape shown in FIG. 14,
   ,
   (a) showing the step of forming an adhesive portion,
   (b) showing the step of preparing the conductive wires; and
   (c) showing the step of press-fitting the conductive wires into the adhesive portion;
FIG. 16 shows a perspective view of a conductive adhesive tape (a form in which a conductive portion includes conductive materials each having a generally rectangular cross-sectional shape) as yet another embodiment of the conductive adhesive member of the present invention;
FIG. 17 is a process step view for illustrating a method of producing the conductive adhesive tape shown in FIG. 16,
   ,
   (a) showing the step of laminating a conductive sheet on an exfoliate sheet,
   (b) showing the step of removing the portions of the conductive sheet each corresponding to an adhesive portion, and
   (c) showing the step of forming the adhesive portion;
FIG. 18 shows a perspective view of a conductive adhesive tape (a form in which adhesive portions are formed over and under a conductive portion) as still another embodiment of the conductive adhesive member of the present invention;
FIG. 19 shows a perspective view of another embodiment (a form in which photoelectric conversion portions are crystal-silicon-based) of the solar cell module of the present invention;
FIG. 20 shows a plan view of the solar cell module shown in FIG. 19;
FIG. 21 shows an enlarged view of the solar cell module shown in FIG. 20, which is a side cross-sectional view along the line A-A;
FIG. 22 shows a perspective view illustrating a state of connection between a specimen and a terminal which are used for the evaluation (contact resistance test) of Examples;
FIG. 23 is a graph showing a relationship between a resistance and a contact area between conductive regions and the terminal in the contact resistance test;
FIG. 24 shows a plan view of a sample for evaluation used in the evaluation (durability test) of Examples; and
FIG. 25 shows a front cross-sectional view along the line B-B of the sample for the evaluation of Examples shown FIG. 24.

### DETAILED DESCRIPTION OF THE INVENTION

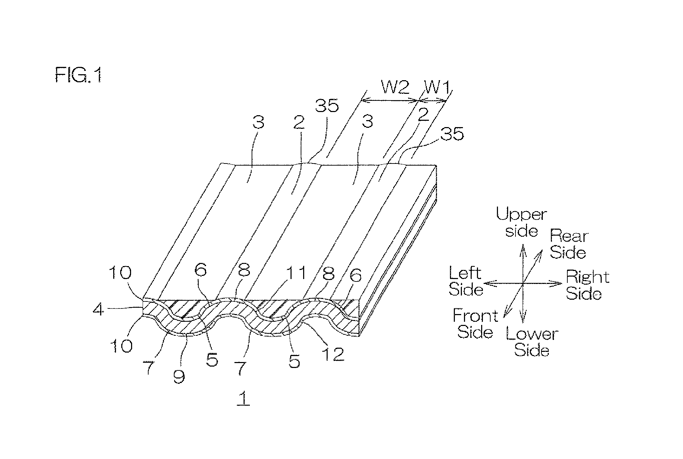

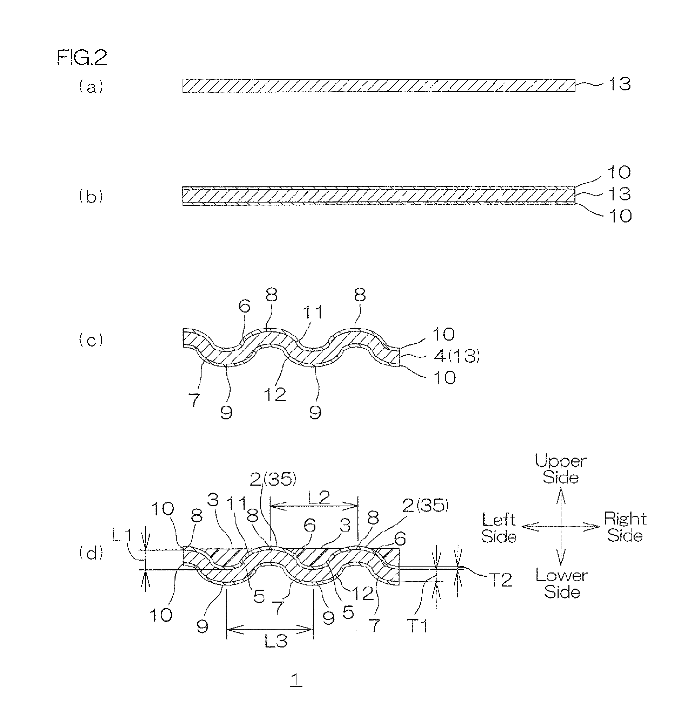

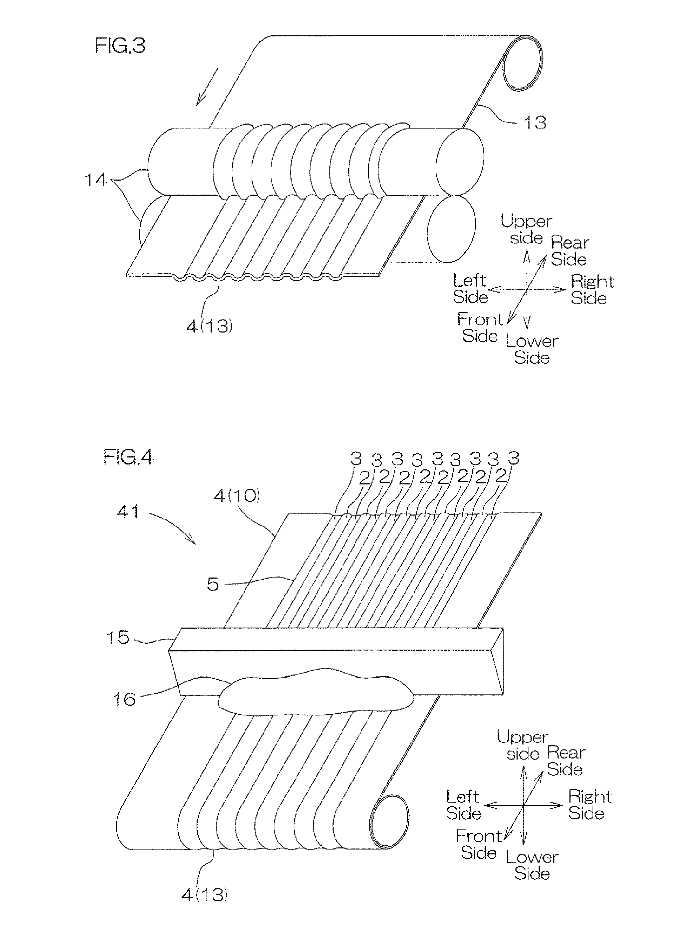

FIG. 1 shows a perspective view of a conductive adhesive tape as an embodiment of a conductive adhesive member of the present invention. FIG. 2 is a process step view for illustrating a method of producing the conductive adhesive tape shown in FIG. 1. FIG. 3 shows a perspective view illustrating the step of bending the conductive plate of FIG. 2(c). FIG. 4 shows a perspective view illustrating the step of forming the adhesive portions of FIG. 2(d).

Note that, in FIG. 2, a description is given on the assumption that a vertical direction of paper with FIG. 2 is a vertical direction, a lateral direction of the paper with FIG. 2 is a lateral direction, and a direction of depth relative to the plane of the paper with FIG. 2 is a front-rear direction. The directions in each of the subsequent drawings are based on the directions shown in FIG. 2.

In FIGS. 1 and 2(d), a conductive adhesive tape 1 is formed in an elongated tape shape which is long in the front-rear direction, and includes a conductive portion 4 and adhesive portions 5.

The conductive portion 4 is formed as a single sheet (corrugated sheet) formed to have a generally S-shaped corrugated cross section (cross section along the vertical direction and the lateral direction). Specifically, the conductive portion 4 integrally includes a plurality of upper sections 6 each upwardly protruding into a generally arcuate (generally semi-arcuate) shape, and a plurality of lower sections 7 each downwardly protruding from the both lateral end portions of the corresponding upper section 6 into a generally arcuate (generally semi-arcuate) shape. Therefore, the lateral middle portions of the upper sections 6 are assumed to be top portions 8 located in the uppermost portions of the upper sections 6, and the lateral middle portions of the lower sections 7 are assumed to be bottom portions 9 located in the lowermost portions of the lower sections 7.

The upper sections 6 and the lower sections 7 are alternately provided along the lateral direction. It is also assumed that the portions of the conductive portion 4 interposed between the individual top portions 8 in the lateral direction are upper recessed portions 11 which are upwardly opened, and the portions of the conductive portion 4 interposed between the individual bottom portions 9 in the lateral direction are lower recessed portions 12 which are downwardly opened.

The dimensions of the conductive portion 4 are such that a length L1 between the upper surface of each of the top portions 8 and the upper surface of the adjacent bottom portion 9 is in a range of, e.g., 10 to 100 µm, or preferably 20 to 50 µm. When the length L1 exceeds the range shown above, the filling amount of an adhesive may increase to result in a longer curing period, or an amount of a material used may increase to result in higher cost. On the other hand, when the length L is less than the range shown above, the filling amount of the adhesive may decrease, and a sufficient adhesion strength may not be obtained.

A length L2 between the individual top portions 8 in the lateral direction, i.e., a pitch L2 of the top portions 8 is generally the same as a length L3 between the individual bottom portions 9 in the lateral direction, i.e., a pitch L3 of the bottom portions 9. Specifically, the length L2 is in a range of, e.g., 0.5 to 2.0 mm, or preferably 0.5 to 1.0 mm. When the pitch L2 of the top portions 8 and the pitch L3 of the bottom portions 9 exceed the range shown above, a contact area may decrease, and the wide conductive adhesive tape 1 may be needed. When the pitch L2 of the top portions 8 and the pitch L3 of the bottom portions 9 are less than the range shown above, a high-precision processing technique may be needed to result in higher cost.

A thickness T1 of the conductive portion 4 is in a range of, e.g., 10 to 100 µm, preferably 20 to 80 µm, or more preferably 30 to 60 µm. When the thickness T1 of the conductive portion 4 is less than the range shown above, a sufficient strength may not be able to be obtained. When the thickness T1 of the conductive portion 4 exceeds the range shown above, manufacturing cost may increase.

On the surfaces of the conductive portion 4, low-melting-point metal layers 10 are formed.

The low-melting-point metal layers 10 are formed as thin films laminated on the entire upper surface and entire lower surface of the conductive portion 4.

A thickness T2 of each of the low-melting-point metal layers 10 is in a range of, e.g., 0.5 to 30 µm, or preferably 3 to 20 µm.

The adhesive portions 5 are formed on the conductive portion 4. Specifically, the adhesive portions 5 fill the upper recessed portions 11.

That is, the adhesive portions 5 expose the low-melting-point metal layer 10 formed over the upper surfaces (surfaces) of the top portions 8 of the conductive portion 4, while covering the low-melting-point metal layer 10 formed on the upper surface of the conductive portion 4 except for the top portions 8. In other words, the adhesive portions 5 are formed on the upper surface of the low-melting-point metal layer 10 formed on the upper surface of the conductive portion 4 except for the top portions 8.

The upper surfaces of the adhesive portions 5 are formed to be located slightly below the upper surface of the low-melting-point metal layer 10 formed over the upper surfaces of the top portions 8 of the conductive portion 4.

It is assumed that the top portions 8 of the conductive portion 4 each formed into the shape shown above and the low-melting-point metal layer 10 formed over the upper surfaces thereof form conductive regions 2, and the adhesive portions 5 each formed into the shape shown above form adhesive regions 3.

That is, the conductive regions 2 are continuously exposed from the adhesive portions 5 along the front-rear direction (one direction). Also, the conductive regions 2 include a plurality of stripe portions 35 arranged to be spaced apart from each other along the lateral direction correspondingly to the plurality of top portions 8 formed along the lateral direction.

The stripe portions 35 are formed as portions linearly exposed from the adhesive portions 5 along the front-rear direction. A width (lateral length) W1 of each of the stripe portions 35 is in a range of, e.g., 0.2 to 1.7 mm, or preferably 0.2 to 0.7 mm.

The adhesive regions 3 are exposed along the conductive regions 2, and disposed on both lateral sides of each of the stripe portions 35. A width W2 of each of the adhesive regions 3 is in a range of, e.g., 0.3 to 1.8 mm, or preferably 0.3 to 0.8 mm.

Thus, the upper surface of the conductive adhesive tape 1 is formed in a pattern in which the adhesive regions 3 and the conductive regions 2 repeatedly alternate in the lateral direction.

Next, a method of producing the conductive adhesive tape 1 is described with reference to FIG. 2.

The method is implemented by, e.g., a roll-to-roll method.

That is, as shown in FIG. 2(a), a conductive plate 13 is prepared first.

The conductive plate 13 is an elongated sheet (tape) which is long in the front-rear direction. Examples of a conductive material for forming the conductive plate 13 include copper, aluminum, nickel, silver, iron, lead, and an alloy thereof. Among the materials shown above, in terms of conductivity, cost, and workability, copper and aluminum are preferably used or, more preferably, copper is used.

Next, in the method, as shown in FIG. 2(b), the low-melting-point metal layers 10 are formed on the upper surface and lower surface of the conductive plate 13.

Examples of a metal for forming the low-melting-point metal layers 10 include an alloy of at least two metals selected from the group consisting of tin, bismuth, and indium. Preferably, a tin-bismuth alloy or a tin-indium alloy is used.

Note that the concentration of bismuth in a tin-bismuth alloy is in a range of, e.g., 45 to 70 mass%, and the concentration of indium in a tin-indium alloy is in a range of, e.g., 40 to 65 mass%.

When the metal shown above is an alloy, the melting point of the metal (the alloy) is lower than the melting point of each of the metals forming the alloy, and is specifically in the range of 120 to 150°C.

Examples of a method for forming the low-melting-point metal layers 10 include plating or sputtering of the metal shown above, preferably plating, or more preferably electrolytic plating.

Next, in the method, as shown in FIG. 2(c), the conductive plate 13 formed with the low-melting-point metal layers 10 is subjected to bending to form the conductive portion 4 having the shape described above.

Examples of the bending include bending using a mold 14.

As shown in FIG. 3, the mold 14 includes the two roll molds 14 (rotary molds) disposed adjacent to each other in the vertical direction to have axes thereof extending along the lateral direction, and each formed to have a generally S-shaped corrugated cross section (cross section along the lateral direction). The roll molds 14 mesh each other in the vertical direction. The roll molds 14 rotate so as to transport the conductive plate 13 toward the downstream side (front side in FIG. 3) in a direction of transportation.

In the bending, the conductive plate 13 is caused to pass through the gap between the two roll molds 14 along the front-rear direction to be formed into the generally S-shaped corrugated cross-sectional shape by a gripping force (vertical gripping force) exerted by the two roll molds 14.

Next, in the method, as shown in FIG. 2(d), the adhesive portions 5 are formed on the conductive portion 4.

Examples of an adhesive material for forming the adhesive portions 5 include adhesives such as a thermosetting adhesive and a thermoplastic adhesive.

Examples of the thermosetting adhesive include an epoxy adhesive, a thermosetting polyimide adhesive, a phenol adhesive, a urea adhesive, a melamine adhesive, an unsaturated polyester adhesive, a diallyl phthalate adhesive, a silicone adhesive, and a thermosetting urethane adhesive.

Examples of the thermoplastic adhesive include an acrylic adhesive, a rubber adhesive, and a polyolefin adhesive.

As the adhesive, the thermosetting adhesive is preferably used and, more preferably, the epoxy adhesive is used.

For example, the epoxy adhesive contains an epoxy resin and a curing agent in appropriate proportions.

Specific examples of the epoxy resin include an aromatic epoxy resin such as a bisphenol type epoxy resin (such as, e.g., bisphenol A type epoxy resin, bisphenol F type epoxy resin, bisphenol S type epoxy resin, hydrogenated bisphenol A type epoxy resin, or dimer-acid-modified bisphenol type epoxy resin), a novolak type epoxy resin (such as, e.g., phenol novolak type epoxy resin, cresol novolak type epoxy resin, or biphenyl type epoxy resin), a naphthalene type epoxy resin, a fluorene type epoxy resin (such as, e.g., bisaryl fluorene type epoxy resin), or a triphenyl methane type epoxy resin (such as, e.g., trishydroxyphenylmethane type epoxy resin), a nitrogen-containing cyclic epoxy resin such as triepoxypropyl isocyanurate (triglycidylisocyanurate) or a hydantoin epoxy resin, an aliphatic epoxy resin, an alicyclic epoxy resin (such as, e.g., dicyclo ring type epoxy resin), a glycidyl ether type epoxy resin, and a glycidyl amine type epoxy resin.

These epoxy resins can be used alone or in combination of two or more kinds.

The curing agent is a latent curing agent (epoxy resin curing agent) which can cure an epoxy resin through heating. Examples of the curing agent include an amine compound, an acid anhydride compound, an amide compound, a hydrazide compound, and an imidazoline compound. Besides the compounds shown above, a phenol compound, a urea compound, a polysulfide compound, or the like can also be used.

Examples of the amine compound include polyamines such as ethylenediamine, propylenediamine, diethylenetriamine, and triethylenetetramine, amine adducts thereof, metaphenylenediamine, diaminodiphenylmethane, and diaminodiphenylsulfone.

Examples of the acid anhydride compound include phthalic anhydride, maleic anhydride, tetrahydrophthalic anhydride, hexahydrophthalic anhydride, 4-methyl-hexahydrophthalic anhydride, methylnadic anhydride, pyromellitic anhydride, dodecenylsuccinic anhydride, dichlorosuccinic anhydride, benzophenonetetracarboxylic anhydride, and chlorendic anhydride.

Examples of the amide compound include dicyandiamide, and polyamide.

Examples of the hydrazide compound include adipic dihydrazide.

Examples of the imidazoline compound include methylimidazoline, 2-ethyl-4-methylimidazoline, ethylimidazoline, isopropylimidazoline, 2,4-dimethylimidazoline, phenylimidazoline, undecylimidazoline, heptadecylimidazoline, and
2-phenyl-4-methylimidazoline.

These curing agents can be used alone or in combination of two or more kinds.

As necessary, to the epoxy adhesive, a known additive such as, e.g., a curing accelerator can also be added in a proper proportion.

Examples of the curing accelerator include imidazole compounds such as 2-phenylimidazole, 2-methylimidazole, 2-ethyl-4-metylimidazole, and 2-phenyl-4-methyl-5-hydroxymethylimidazole, tertiary amine compounds such as triethylenediamine and tri-2,4,6-dimethylaminomethylphenol, phosphorus compounds such as triphenylphosphine, tetraphenylphosphoniumtetraphenylborate, and tetra-n-butylphosphonium-o,o-diethylphosphorodithioate, quaternary ammonium salt compounds, organic metal salt compounds, and derivatives thereof. These curing accelerators can be used alone or in combination of two or more kinds.

As the adhesive, a thermoplastic adhesive can also be preferably used, or more preferably, an acrylic adhesive can be used.

The acrylic adhesive is a polymer of a vinyl monomer which contains, e.g., (meta)acrylic acid alkyl ester such as butyl (meta)acrylate as a main component thereof, and further contains a reactive functional group-containing vinyl monomer such as (meta)acrylic acid as necessary.

Each of the adhesives shown above can also be dissolved in a solvent and prepared as a solution (varnish). Examples of the solvent include organic solvents. Examples of the organic solvent includes ketones such as acetone and methylethylketone, esters such as ethyl acetate, amides such as N-N-dimethylformamide and N-methyl-2-pyrrolidone. Also, examples of the solvent can include aqueous solvents. Examples of the aqueous solvents include water, alcohols such as methanol, ethanol, propanol and isopropanol. Preferably, the organic solvents are used, or more preferably, ketones or amides are used.

Examples of a method for forming the adhesive shown above include a coating method such as a blade coater method or a gravure coater method. Preferably, a blade coater method is used.

In the blade coater method, as shown in FIG. 4, a blade coater 41 including a blade 15 is used as a coating device (coater).

The blade 15 is a squeegee made of, e.g., a known resin material such as an elastomer resin. The blade 15 is provided along the lateral direction to have a lower end portion thereof in contact with the upper surface of the low-melting-point metal layer 10 formed over the upper surfaces of the top portions 8 of the conductive portion 4, and also provided slidably relative to the conductive portion 4 and the low-melting-point metal layer 10 which are transported toward the downstream side (rear side) in the direction of transportation.

In the blade coater method, the adhesive is disposed on the conductive portion 4 into the form of a clump according to an amount of coating to form a coating pool 16. The coating pool 16 is formed thick on the upper surface of the low-melting-point metal layer 10 and in front of the blade 15 to extend in the lateral direction.

Thereafter, for example, the blade 15 is relatively slid toward the upstream side in the direction of transportation with respect to the conductive portion 4 and the low-melting-point metal layer 10, while being pressed against the low-melting-point metal layer 10 formed over the upper surfaces of the top portions 8 of the conductive portion 4.

Specifically, by the relative sliding of the blade 15 along the upper surface of the low-melting-point metal layer 10 formed over the upper surfaces of the top portions 8, the coating pool 16 formed on the upper surface of the low-melting-point metal layer 10 formed over the upper surfaces of the top portions 8 is scraped (wiped) away. As a result, the low-melting-point metal layer 10 over the top portions 8 is exposed so that the conductive regions 2 are formed.

At the same time, the coating pool 16 formed on the upper surface of the low-melting-point metal layer 10 except for the top portions 8 fills the inside of the upper recessed portions 11, while the upper portion of the filling coating pool 16 is scraped away to form the adhesive portions 5. Specifically, the coating pool 16 is leveled such that the upper surfaces of the adhesive portions 5 are slightly lower in level than the upper surfaces of the top portions 8.

Thereafter, as necessary, drying is performed to distil the solvent away.

Subsequently, when the adhesive material is a thermosetting adhesive, the adhesive material is brought into a stage B state (semi-cured state) by heating. A heating temperature is in a range of, e.g., 30 to 80 °C, or preferably 40 to 60 °C.

In this manner, the adhesive portions 5 are formed to obtain the conductive adhesive tape 1 including the adhesive regions 3 and the conductive regions 2.

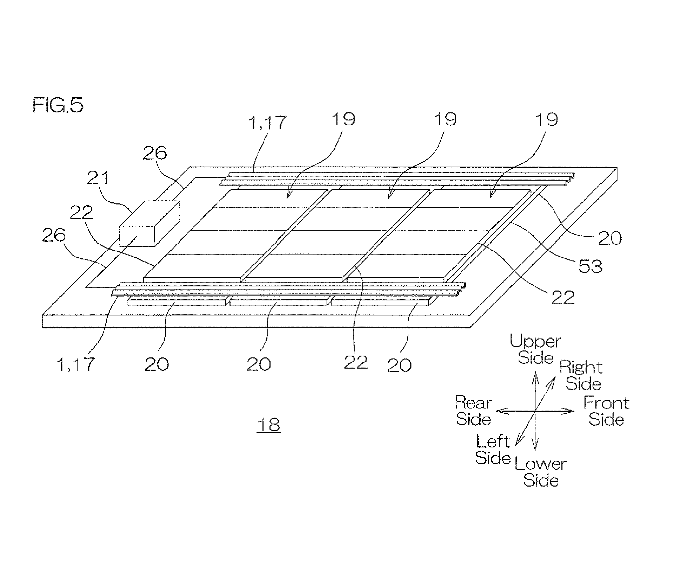

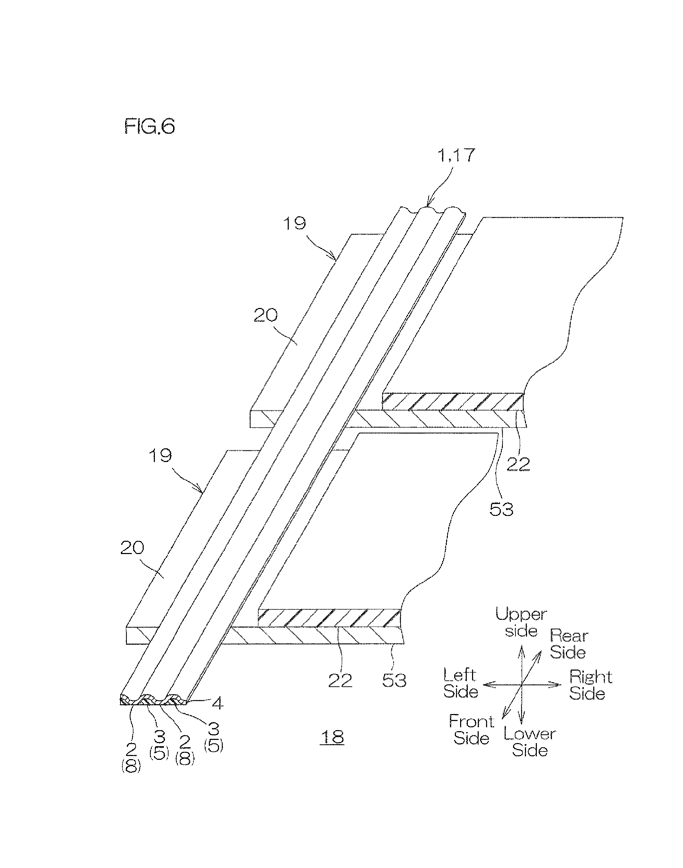

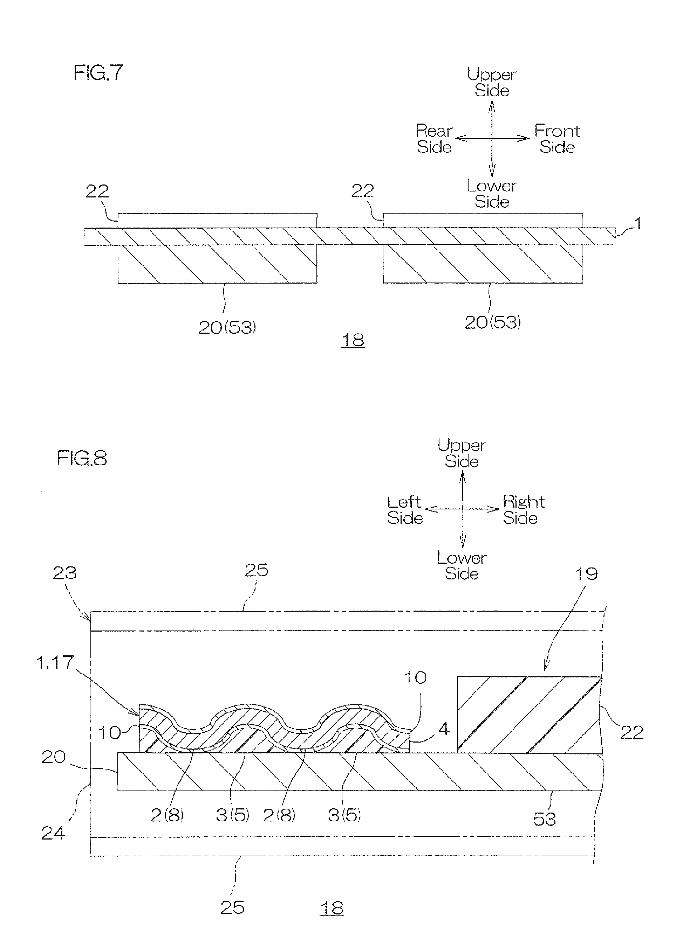

FIG. 5 shows a perspective view of an embodiment (a form in which photoelectric conversion portions are amorphous-silicon-based) of a solar cell module of the present invention. FIG. 6 shows an enlarged perspective view illustrating a connection structure between terminals and collector electrodes (left-hand portion). FIG. 7 shows a side cross-sectional view of the connection structure of FIG. 6. FIG. 8 shows a front cross-sectional view of the connection structure of FIG. 6. Note that, in FIGS. 5 to 7, a protective portion 23 is omitted to clearly show the relative positioning of solar cells 19 and collector electrodes 17.

Next, a description is given to the embodiment (the form in which the photoelectric conversion portions are amorphous-silicon-based) of the solar cell module of the present invention in which the conductive adhesive tape 1 is used as each of the collector electrodes 17 with reference to FIGS. 5 to 8.

In FIG. 5, a solar cell module 18 includes the solar cells 19 and the collector electrodes 17. The solar cell module 18 also includes a retrieval portion 21 and the protective portion 23 (see the imaginary line of FIG. 8).

The plurality of solar cells 19 are arranged in parallel in the front-rear direction. Each of the solar cells 19 is formed in a generally rectangular plan view shape which is long in the lateral direction. The solar cell 19 includes wiring plates 53 and photoelectric conversion portions 22.

The wiring plates 53 are formed under the lower surfaces of the photoelectric conversion portions 22 to define the outer shapes of the solar cells 19. Specifically, each of the wiring plates 53 is formed in a generally rectangular plan view shape which extends long in the lateral direction.

The photoelectric conversion portions 22 are formed of, e.g., amorphous-silicon-based solar cell elements on the upper surfaces of the wiring plates 53. The plurality of solar cell elements are arranged in juxtaposition in the lateral direction. The photoelectric conversion portions 22 generate carriers (electrons or holes) by receiving solar light. The photoelectric conversion portions 22 are disposed at respective middle points (middles) of the wiring plates 53 in the lateral direction so as to expose the both lateral end portions of the wiring plates 53.

The both lateral end portions of the wiring plates 53 having upper surfaces thereof exposed from the photoelectric conversion portions 22 are used as terminals 20.

The two collector electrodes 17 are each formed of the conductive adhesive tape 1 described above, and disposed to extend along the front-rear direction so as to connect the individual terminals 20. That is, one of the collector electrodes 17 (on the right) is provided so as to electrically connect the terminals 20 disposed at the respective right end portions of the individual photoelectric conversion portions 22. On the other hand, the other collector electrode 17 (on the left) is provided so as to electrically connect the terminals 20 disposed at the respective left end portions of the individual photoelectric conversion portions 22.

As shown in FIGS. 6 and 8, the collector electrodes 17 are disposed such that the conductive regions 2 and the adhesive regions 3 are disposed to face the upper surfaces of the terminals 20. Specifically, the conductive regions 2 and the adhesive regions 3 face downward, and the conductive regions 2 come in contact with the upper surfaces of the terminals 20, while the adhesive regions 3 are bonded to the upper surfaces of the terminals 20.

In the conductive regions 2, the top portions 8 of the conductive portion 4 are joined (metallically joined) to the terminals 20 via the low-melting-point metal layer 10.

As shown in FIGS. 5 to 7, the collector electrodes 17 are disposed (to span) over the plurality of terminals 20 juxtaposed in the front-rear direction.

As shown by the imaginary line of FIG. 8, the protective portion 23 is provided to protect the solar cells 19 and the collector electrodes 17, and includes a sealing layer 24 and glass plates 25.

The sealing layer 24 seals the solar cells 19 and the collector electrodes 17, which are buried in the sealing layer 24. That is, the sealing layer 24 is formed over, under, and around the solar cells 19 and the collector electrodes 17. Examples of a material for forming the sealing layer 24 include a sealing resin such as an ethylene-vinyl acetate copolymer (EVA) or polyvinyl butyral (PVB). A melting temperature of the sealing resin is in a range of, e.g., 40 to 70 °C, and a curing (cross-linking) temperature thereof is in a range of, e.g., 120 to 180 °C.

The two glass plates 25 are formed so as to cover the upper and lower surfaces of the sealing layer 24.

As shown in FIG. 5, the retrieval portion 21 is connected to the two collector electrodes 17 via wires 26.

To produce the solar cell module 18, e.g., the plurality of solar cells 19 are prepared, and the collector electrodes 17 each formed of the conductive adhesive tape 1 are prepared.

Then, the lower glass plate 25 is prepared, and the lower portion of the sealing layer 24 is formed thereon. Subsequently, over the lower portion of the sealing layer 24, the plurality of solar cells 19 are disposed. After the collector electrodes (each of which is the conductive adhesive tape 1 shown FIG. 1) are then vertically inverted, the conductive regions 2 and the adhesive regions 3 of the collector electrodes 17 are disposed to face the upper surfaces of the terminals 20, and placed over the upper surfaces of the terminals 20.

Then, with the upper and surrounding sealing layer 24, each of the solar cells 19 and the collector electrodes 17 is covered. Subsequently, with the upper glass plate 25, the upper surface of the sealing layer 24 is covered, whereby a laminate is produced.

Thereafter, the laminate is heated.

A heating temperature is in a range of, e.g., 130 to 200 °C, or preferably 120 to 160 °C. A heating time is in a range of, e.g., 5 to 60 minutes, or preferably 5 to 40 minutes.

Simultaneously with the heating described above, compression (i.e., thermocompression) can also be performed. A pressure is in a range of, e.g., 0.5 to 10 MPa, or preferably 1 to 5 MPa.

By the heating, the sealing resin of the sealing layer 24 is melted and cured (cross-linked) to seal the solar cells 19 and the collector electrodes 17.

Also, by the heating, the metal forming the low-melting-point metal layers 10 in the conductive regions 2 of the collector electrodes 17 is melted so that, via the metal, the lower surfaces of the top portions 8 of the conductive portion 4 and the upper surfaces of the terminals 20 are joined to each other. Meanwhile, in the adhesive regions 3, when the adhesive material is a thermosetting adhesive, the thermosetting adhesive is cured (completely cured) to bond the adhesive portions 5 to the upper surfaces of the terminals 20.

As a result, the collector electrodes 17 are solidly bonded to the terminals 20, while conduction occurs between the collector electrodes 17 and the terminals 20.

Thereafter, the collector electrodes 17 are connected to the retrieval portion 21 either directly or via the wires 26.

In this manner, the solar cell module 18 is obtained.

In the solar cell module 18, by the reception of solar light by the photoelectric conversion portions 22, carries are generated. The generated carriers are collected by the two collector electrodes 17 via the plurality of terminals 20, and retrieved as electricity from the retrieval portion 21.

In the conductive adhesive tapes 1 described above, the conductive regions 2 are exposed, and therefore can be reliably brought into contact with the terminals 20. In addition, since the conductive regions 2 are continuously exposed along the front-rear direction, sufficient contact areas can be ensured between the conductive regions 2 and the terminals 20.

On the other hand, the adhesive regions 3 are exposed along the conductive regions 2. Therefore, when bonded to the terminals 20, the adhesive regions 3 can reliably bring the conductive regions 2 into contact with the terminals 20, and maintain the state of contact over a long period.

When the adhesive regions 3 are bonded to the terminals 20, the conductive regions 2 and the terminals 20 are brought into direct contact with each other, and therefore it is possible to prevent the adhesive material from entering the gaps between the conductive regions 2 and the terminals 20.

Therefore, it is possible to ensure the excellent conductivities between the conductive regions 2 and the terminals 20 and excellent durability which allows the conductivities to be maintained over a long period so that the conductive adhesive tape 1 has excellent conductivity and durability.

When the conductive adhesive tapes 1 are used as the collector electrodes 17, carries generated in the solar cells 19 can be reliably collected so that the solar cell module 18 including the solar cells 19 and the collector electrodes 17 has excellent power generation efficiency.

Note that, in the description given above, the adhesive regions 3 are disposed on both sides (lateral both sides) of each of the conductive regions 2 (stripe portions 35), but it is also possible to, e.g., dispose the adhesive region 3 on one side (lateral one side) of the conductive region 2 (stripe portion 35), though not shown.

In that case, the one stripe portion 35 is provided, i.e., the one upper section 6 of the conductive portion 4 and the one lower section 7 thereof are provided, and the adhesive portion 5 fills the one upper recessed portion 11. In this manner, the adhesive region 3 is disposed on one side of the conductive region 2 formed correspondingly to the one stripe portion 35.

Preferably, as shown in FIG. 1, the adhesive regions 3 are disposed on both sides of each of the conductive regions 2, and the plurality of stripe portions 35 are provided.

Thus, it is possible to improve the adhesive forces between the adhesive regions 3 and the terminals 20, and also more sufficiently ensure the contact areas between the conductive regions 2 and the terminals 20.

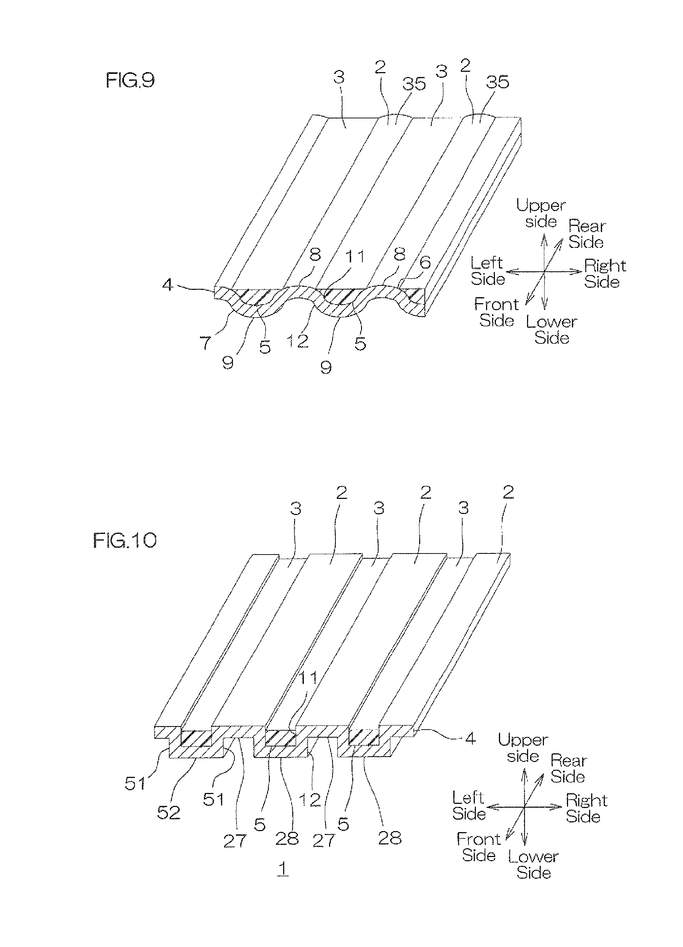

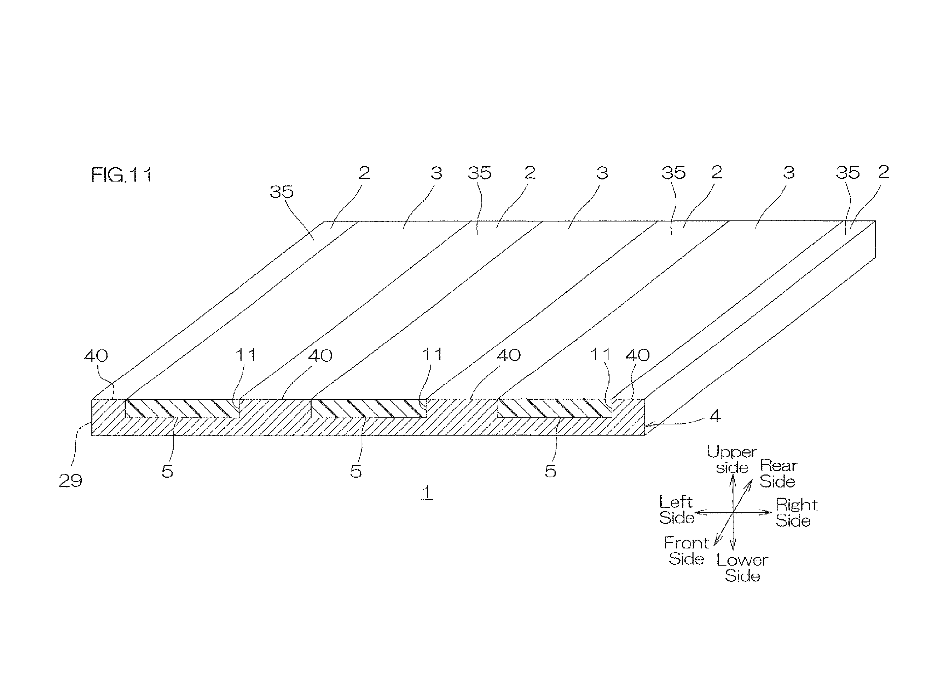

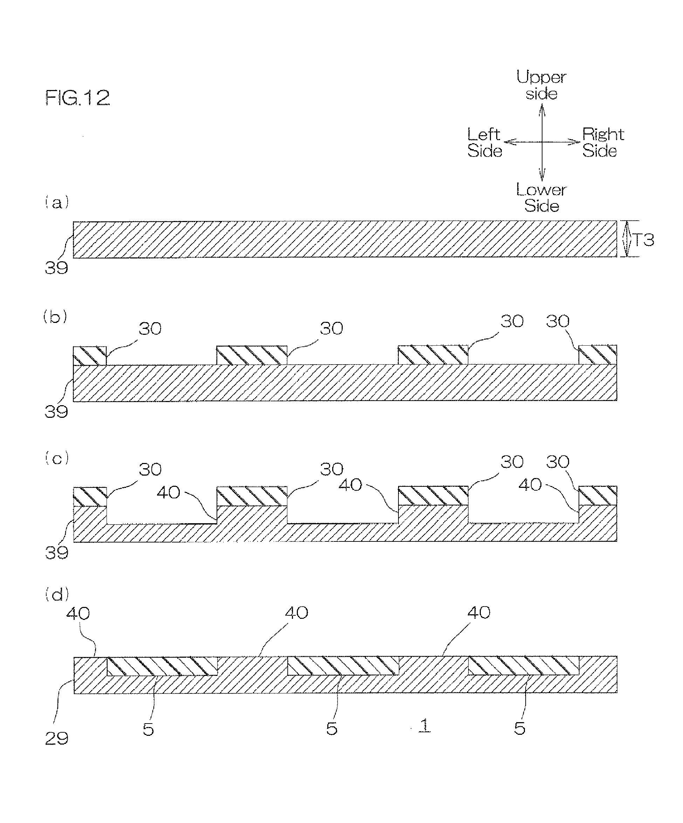

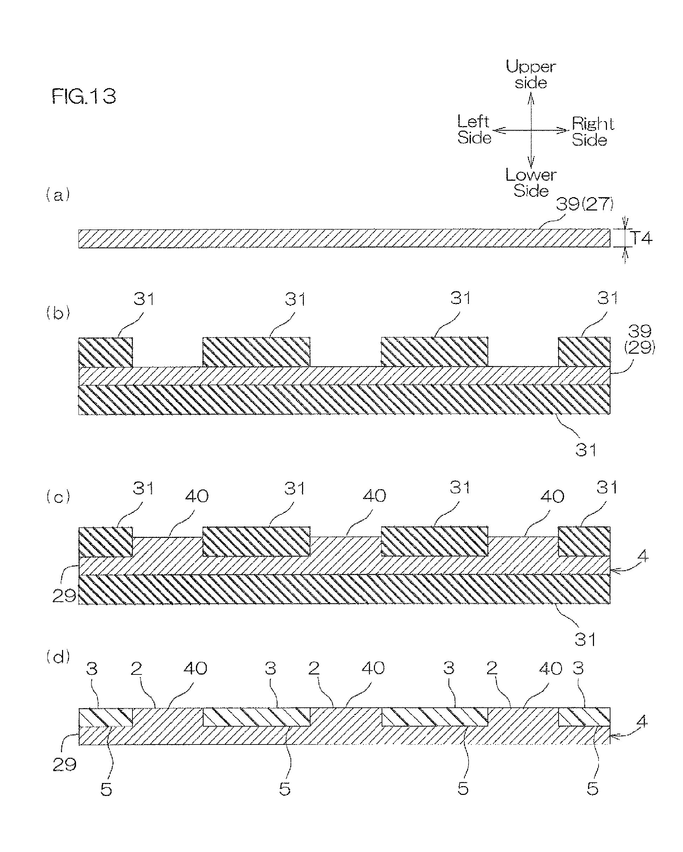

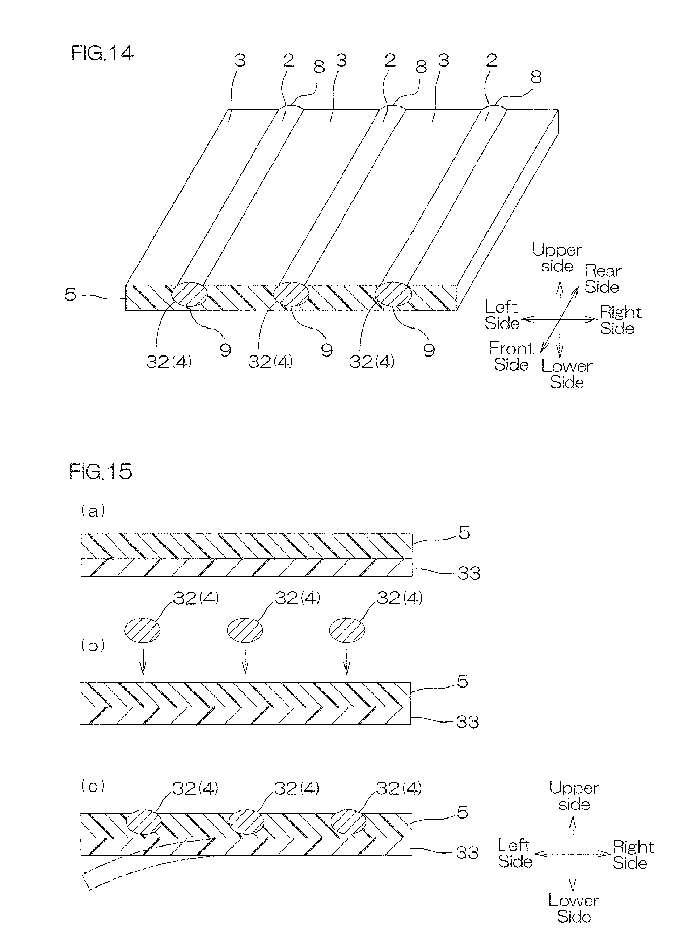

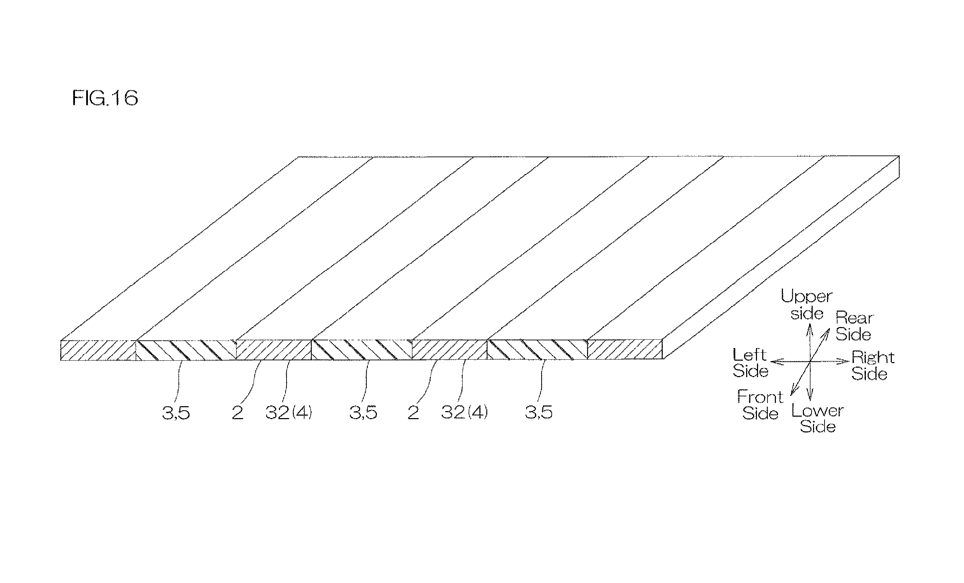

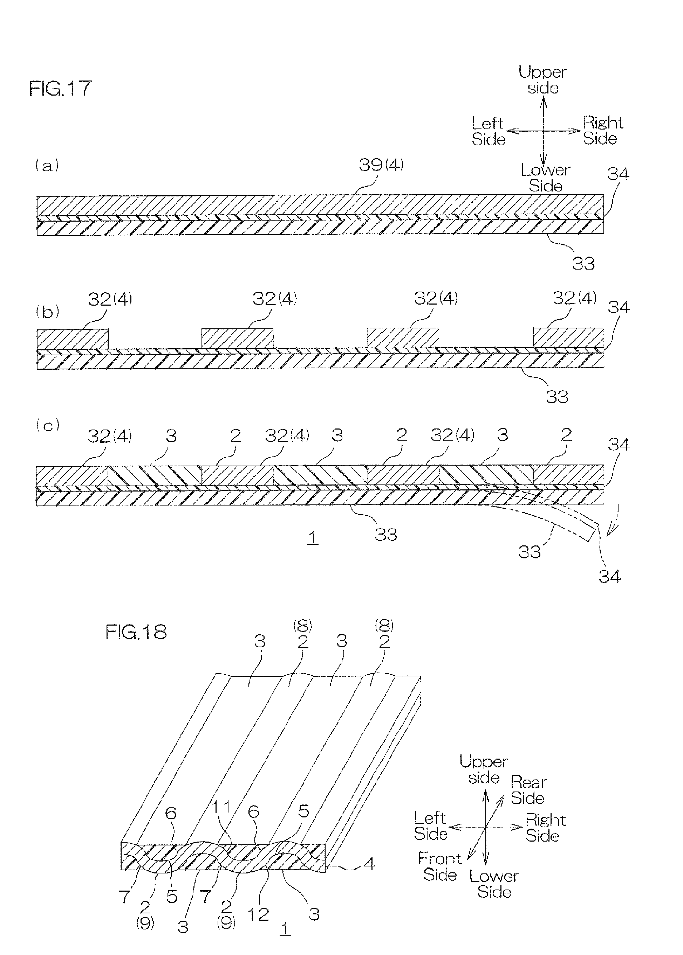

FIG. 9 shows a perspective view of a conductive adhesive tape (a form in which low-melting-point metal layers are not formed) as another embodiment of the conductive adhesive member of the present invention. FIG. 10 shows a perspective view of a conductive adhesive tape (a form in which a conductive portion is formed in a generally meandering cross-sectional shape) as still another embodiment of the conductive adhesive member of the present invention. FIG. 11 shows a perspective view of a conductive adhesive tape (a form in which a conductive portion is formed in a generally comblike cross-sectional shape) as yet another embodiment of the conductive adhesive member of the present invention. FIGS. 12 and 13 are process step views for illustrating a method of producing the conductive adhesive tape shown in FIG. 11. FIG. 14 shows a perspective view of a conductive adhesive tape (a form in which a conductive portion includes conductive wires each having a generally ellipsoidal cross-sectional shape) as still another embodiment of the conductive adhesive member of the present invention. FIG. 15 is a process step view for illustrating a method of producing the conductive adhesive tape shown in FIG. 14. FIG. 16 shows a perspective view of a conductive adhesive tape (a form in which a conductive portion includes conductive materials each having a generally rectangular cross-sectional shape) as yet another embodiment of the conductive adhesive member of the present invention. FIG. 17 is a process step view for illustrating a method of producing the conductive adhesive tape shown in FIG. 16. FIG. 18 shows a perspective view of a conductive adhesive tape (a form in which adhesive portions are formed over and under a conductive portion) as still another embodiment of the conductive adhesive member of the present invention.

Note that, in FIGS. 10 to 18, the low-melting-point metal layers 10 are omitted to clearly show the relative positioning of the conductive portion 4 and the adhesive portions 5.

In each of the subsequent drawings, members corresponding to the individual components described above are designated by the same reference numerals, and a detailed description thereof is omitted.

In the description given above, over the surfaces of the conductive regions 2, the low-melting-point metal layer 10 is formed but, as shown in FIG. 9, it is also possible to, e.g., expose the conductive portion 4 at the surface without forming the low-melting-point metal layer 10 over the surfaces.

In FIG. 9, the top portions 8 of the conductive portions 4 are exposed from the adhesive portions 5, and the upper surface of the conductive portion 4 except for the top portions 8 is in contact with the adhesive portions 5.

The top portions 8 of the conductive portion 4 are used as the conductive regions 2.

In the case of producing the solar cell module 18 in which the conductive adhesive tapes 1 are used as the collector electrodes 17, by heating the laminate, the conductive regions 2 come in contact (abutment) with the upper surfaces of the terminals 20 without being metallically joined to the upper surfaces of the terminals 20 via the low-melting-point metal layer 10.

Preferably, as shown in FIG. 1, the low-melting-point metal layer 10 is formed over the surfaces of the conductive regions 2.

In this manner, as shown in FIG. 8, by the melting of the metal forming the low-melting-point metal layer 10, the conductive portion 4 and the terminals 20 are solidly jointed to each other, and therefore it is possible to ensure more excellent conductivity and durability.

In the description given above, the conductive portion 4 is formed in a generally S-shaped corrugated cross-sectional shape. However, the conductive portion 4 can also be formed in, e.g., a generally meandering (or zigzag) cross-sectional shape, as shown in FIG. 10.

In FIG. 10, the conductive portion 4 includes flat portions 27 and U-shaped portions 28 having generally U-shaped cross-sectional shapes which are downwardly recessed in continuous relation to the both lateral end portions of the flat portions 27, and upwardly opened.

Each of the U-shaped portions 28 integrally includes two side walls 51 facing each other and a bottom wall 52 connecting the side walls 51.

The U-shaped portions 28 form the upper recessed portions 11 as recessed portions, while the flat portions 27 and the side walls 51 of the U-shaped portions 28 form the lower recessed portions 12.

The adhesive portions 5 fill the upper recessed portions 11.

As a result, the upper surfaces of the flat portions 27 are exposed so that the flat portions 27 are used as the conductive regions 2, and the adhesive portions 5 are used as the adhesive regions 3.

Otherwise, as shown in FIG. 11, the conductive portion 4 can also be formed in a generally comblike cross-sectional shape.

The conductive portion 4 integrally includes a flat plate portion 29 and projecting portions 40 upwardly projecting from the flat plate portion 29.

The flat plate portion 29 is formed continuously in the lateral direction.

Each of the projecting portions 40 is formed so as to upwardly project from the upper portion of the flat plate portion 29 into a generally rectangular cross-sectional shape. The plurality of projecting portions 40 are arranged to be spaced apart from each other in the lateral direction. The projecting portions 40 form the stripe portions 35.

The projecting portions 40 and the flat plate portion 29 exposed between the projecting portions 40 form the upper recessed portions 11 as the recessed portions.

The adhesive portions 5 fill the upper recessed portions 11.

As a result, the upper surfaces of the projecting portions 40 are exposed so that the projecting portions 40 are used as the conductive regions 2 and the adhesive portions 5 are used as the adhesive regions 3.

Next, a method of producing the conductive adhesive tape 1 of FIG. 11 is described with reference to FIG. 12.

In the method, as shown in FIG. 12(a), a conductive sheet 39 having an elongated flat plate shape is prepared first.

The conductive sheet 39 is formed of the same conductive material as that of the conductive plate 13 described above. A thickness T3 of the conductive sheet 39 is in a range of, e.g., 12 to 50 µm, or preferably 25 to 35 µm.

Next, as shown in FIG. 12(b), an etching resist 30 is formed in the same pattern as that of the projecting portions 40 on the upper surface of the conductive sheet 39.

Next, as shown in FIG. 12(c), the conductive sheet 39 exposed from the etching resist 30 is half-etched from above to a predetermined point along the thickness direction thereof. As a result, the projecting portions 40 and the flat plate portion 29 are formed.

Thereafter, the etching resist 30 is removed.

Next, as shown in FIG. 12(d), the upper recessed portions 11 are filled with the adhesive portions 5. Examples of a method for filling with the adhesive portions 5 include the same coating method as mentioned above. Note that, when the adhesive material is a thermosetting adhesive, the adhesive material is brought into a stage B state (semi-cured state) by heating.

In this manner, the conductive adhesive tape 1 of FIG. 11 is obtained.

In the method described above, the projecting portions 40 are formed by etching the conductive sheet 39. However, as shown in FIG. 13, the projecting portions 40 can also be formed by, e.g., plating or the like.

That is, in the method, as shown in FIG. 13 (a), the conductive sheet 39 serving as the flat plate portion 29 is prepared. Note that the conductive sheet 39 shown in FIG. 13(a) is formed thinner than the conductive sheet 39 shown in FIG. 12(a) by a thickness corresponding to the projecting portions 40. Specifically, a thickness T4 of the conductive sheet 39 shown in FIG. 13(a) is in a range of, e.g., 1 to 10 µm, or preferably 2 to 5 µm.

Then, as shown in FIG. 13(b), a plating resist 31 is formed in a pattern reverse to that of the projecting portions 40 on the upper surface of the conductive sheet 39. Note that the plating resist 31 is formed also on the entire lower surface of the conductive sheet 39.

Then, as shown in FIG. 13(c), the projecting portions 40 are formed on the conductive sheet 39 by plating such as, e.g., electrolytic plating or electroless plating.

Thereafter, the plating resist 31 is removed.

Then, as shown in FIG. 13(d), the upper recessed portions 11 are filled with the adhesive portions 5. Note that, when the adhesive material is a thermosetting adhesive, the adhesive material is brought into a stage B state (semi-cured state) by heating.

In the description given above, the conductive portion 4 is formed of one sheet. However, as shown in FIGS. 14 and 16, the conductive portion 4 can also be formed of a plurality of conductive wires 32.

In FIG. 14, the adhesive portion 5 is in the form of one sheet extending in the front-rear direction and in the lateral direction. Specifically, the adhesive portion 5 is formed in a generally rectangular plan view shape.

The conductive portion 4 includes the plurality of conductive wires 32, and the conductive wires 32 are arranged in juxtaposition to be spaced apart from each other in the lateral direction. Each of the conductive wires 32 extends along the front-rear direction, and is formed in a generally ellipsoidal shape which is long in the lateral direction when viewed in cross section.

The upper surfaces of the top portions 8 of the conductive wires 32 are exposed from the adhesive portion 5, while the circumferential surfaces of the conductive wires 32 (the middle portions of the conductive wires 32 in the thickness direction and the lower sections 7 thereof) except for the top portions 8 are covered with the adhesive portion 5.

The top portions 8 of the conductive wires 32 form the conductive regions 2, and the adhesive portion 5 forms the adhesive regions 3.

Next, a method of producing the conductive adhesive tape 1 including the conductive regions 2 and the adhesive regions 3, which are described above, is described with reference to FIG. 15.

In the method, as shown in FIG. 15 (a), the adhesive portion 5 is formed on the upper surface of an exfoliate sheet 33. The adhesive portion 5 is formed by a known coating method for coating an adhesive material.

The exfoliate sheet 3 is formed of a known resin sheet such as, e.g., a PET (polyethylene terephthalate) sheet.

Note that, when the adhesive material is a thermosetting adhesive, the adhesive material is brought into a stage B state (semi-cured state) by heating.

Then, as shown in FIG. 15(b), the plurality of conductive wires 32 are prepared. Subsequently, as shown by the arrow of FIG. 15(b) and in FIG. 15(c), each of the conductive wires 32 is press-fitted into the adhesive portion 5. The conductive wires 32 are press-fitted such that the top portions 8 thereof are exposed, and the middle portions thereof in the thickness direction and the lower sections 7 (lower sections 7 including bottom portions 9) thereof are buried in the adhesive portion 5.

In this manner, the conductive adhesive tape 1 shown in FIG. 14 is obtained.

In the description given above, each of the conductive wires 32 is formed in the generally ellipsoidal cross-sectional shape, but the cross-sectional shape of the conductive wire 32 is not particularly limited. The conductive wire 32 can be formed into, e.g., a generally circular cross-sectional shape or, alternatively, into a generally polygonal cross-sectional shape such as a generally rectangular cross-sectional shape (FIG. 16) or a triangular cross-sectional shape.

In FIG. 16, each of the conductive wires 32 is formed in a rectangular cross-sectional shape which is long in the lateral direction to extend continuously in the vertical direction so as to divide the adhesive portion 5 in the lateral direction. That is, the conductive wires 32 are formed to extend through the adhesive portion 5 in the vertical direction.

The adhesive portion 5 is formed to be located between the individual conductive wires 32 and entirely cover the both side surfaces of each of the conductive wires 32.

In the conductive portion 4, both the upper and lower surfaces of the conductive wires 32 are exposed, and both the upper and lower sides of the conductive wires 32 are used as the conductive regions 2. In addition, both the upper and lower surfaces of the adhesive portion 5 are exposed, and both the upper and lower sides of the adhesive portion 5 are used as the adhesive regions 3.

Note that the upper and lower surfaces of the conductive wires 32 are formed generally flush with the upper and lower surfaces of the adhesive portion 5 in the vertical direction.

Next, a method of producing the conductive adhesive tape 1 including the conductive regions 2 and the adhesive regions 3, which are described above, is described with reference to FIG. 17.

In the method, as shown in FIG. 17(a), the exfoliate sheet 33 having an adhesive layer 34 laminated in advance on the upper surface thereof is prepared first. Then, on the exfoliate sheet 33, the conductive sheet 39 is laminated via the adhesive layer 34. The adhesive layer 34 is formed of a known adhesive such as, e.g., an epoxy adhesive or an acrylic adhesive.

Next, as shown in FIG. 17(b), the portions of the conductive sheet 39 corresponding to the adhesive portion 5 are removed by etching or stripping. As a result, the conductive portion 4 including the conductive wires 32 is formed.

Thereafter, as shown in FIG. 17(c), the adhesive portion 5 is formed on the upper surface of the adhesive layer 34 exposed from the conductive portion 4. Note that, when the adhesive material is a thermosetting adhesive, the adhesive material is brought into a stage B state (semi-cured state) by heating.

In this manner, the conductive adhesive tape 1 shown in FIG. 16 is obtained.

In the description of FIG. 1 given above, the adhesive portion 5 is formed over the conductive portion 4. However, as shown in FIG. 18, the adhesive portions 5 can also be formed, e.g., on both sides of the conductive portion 4, i.e., over and under the conductive portion 4.

In FIG. 18, the adhesive portions 5 fill both the upper recessed portions 11 of the conductive portion 4 and the lower recessed portions 12 thereof as the recessed portions.

The adhesive portions 5 filling the lower recessed portions 12 cover the lower surface of the portion of the conductive portion 4 other than the bottom portions 9 so as to expose the lower surfaces of the bottom portions 9. The lower surfaces of the adhesive portions 5 filling the lower recessed portions 12 are formed to be located slightly above the lower surfaces of the bottom portions 9 of the conductive portion 4.

The top portions 8 and the bottom portions 9 of the conductive portion 4 are used as the conductive regions 2, while the adhesive portions 5 filling the upper recessed portions 11 and the lower recessed portions 12 are used as the adhesive regions 3.

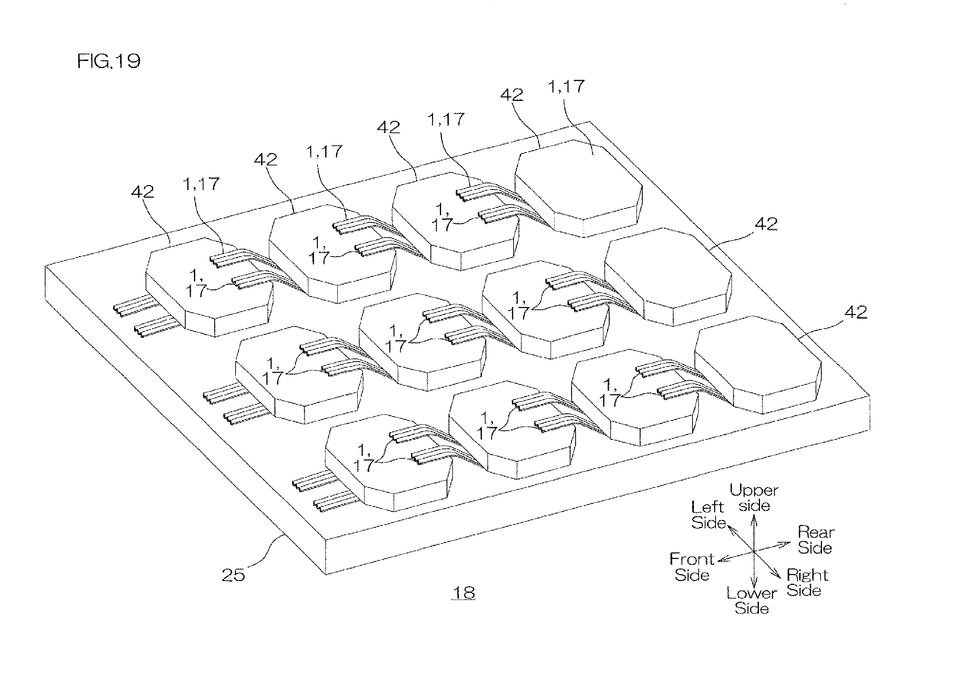

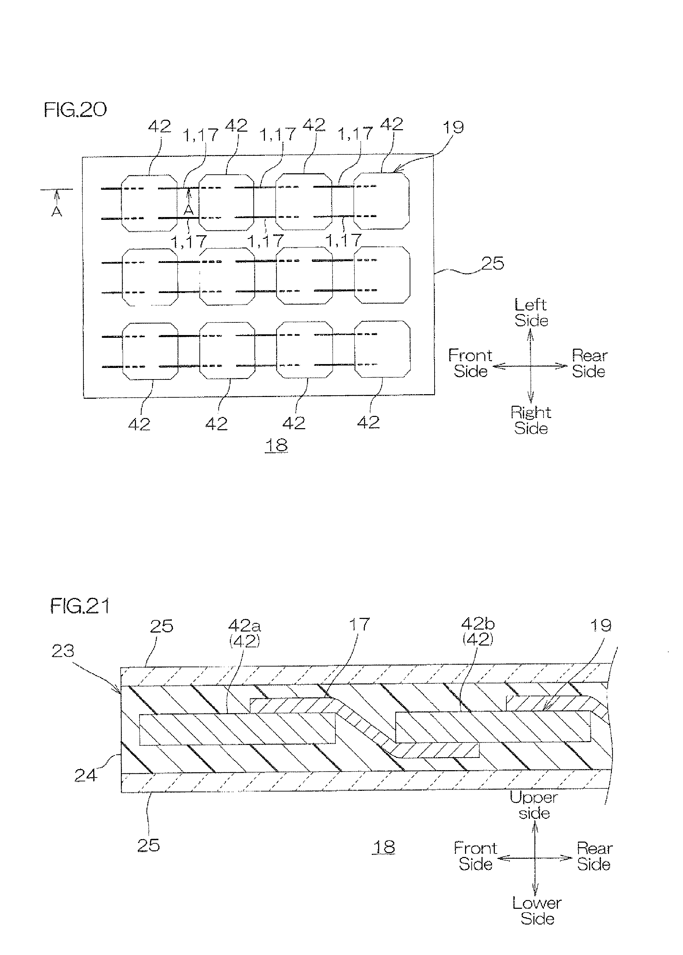

FIG. 19 shows a perspective view of another embodiment (a form in which photoelectric conversion portions are crystal-silicon-based) of the solar cell module of the present invention. FIG. 20 shows a plan view of the solar cell module shown in FIG. 19. FIG. 21 shows an enlarged view of the solar cell module shown in FIG. 20, which is a side cross-sectional view along the line A-A.

Note that, in FIGS. 19 and 20, the protective portion 23 is omitted to clearly show the relative positioning of the solar cells 19 and the collector electrodes 17.

Next, a description is given to the other embodiment (the form in which the photoelectric conversion portions are crystal-silicon-based) of the solar cell module of the present invention in which the conductive adhesive tape 1 shown in FIG. 18 is used as each of the collector electrodes 17 with reference to FIGS. 19 to 21.

In FIGS. 19 and 20, in the solar cell module 18, the plurality of solar cells 19 are arranged to align in the front-rear direction and in the lateral direction. Each of the solar cells 19 is formed in a generally rectangular plan view shape, and includes a photoelectric conversion portion 42 and terminals (not shown).

The photoelectric conversion portion 42 is, e.g., a monocrystalline or polycrystalline silicon-based solar cell element. The photoelectric conversion portion 42 is formed over substantially the entire surface (surface except for the terminals) of each of the solar cells 19, while the two terminals (not shown) are provided on the upper and lower surfaces of the photoelectric conversion portion 42.

The upper terminal has an exposed upper surface, while the lower terminal has an exposed lower surface.

Each of the collector electrodes 17 is formed of the conductive adhesive tape 1 shown in FIG. 18, and electrically connects the solar cells 19 arranged in juxtaposition in the front-rear direction so as to elongatedly extend along the front-rear direction. Specifically, the collector electrode 17 connects the photoelectric conversion portions 42 which are adjacent in the front-rear direction. Note that, for each of the photoelectric conversion portions 42, the two collector electrodes 17 are arranged in parallel lines spaced apart from each other in the lateral direction.

Next, the two photoelectric conversion portions 42 which are adjacent in the front-rear direction are shown by way of example, and a connection structure therebetween using the collector electrodes 17 is described with reference to FIG. 21.

The two photoelectric conversion portions 42 which are adjacent in the front-rear direction include a front part 42a and a rear part 42b disposed behind the front part 42a in spaced-apart relation.

The front end portion of each of the collector electrodes 17 is electrically connected to the terminal formed over the front part 42a, while the rear end portion of the collector electrode 17 is electrically connected to the terminal formed under the rear part 42b.

Specifically, as shown in FIG. 18, at the front end portion of the collector electrode 17, the lower conductive region 2 comes in contact with the upper surface of the terminal (not shown) formed over the front part 42a, while the lower adhesive region 3 adheres to the upper surface of the foregoing terminal (not shown).

On the other hand, at the rear end portion of the collector electrode 17, the upper conductive region 2 comes in contact with the lower surface of the terminal (not shown) formed under the rear part 42b, while the upper adhesive region 3 adheres to the lower surface of the foregoing terminal (not shown).

That is, the upper and lower conductive regions 2 on both sides of the collector electrode 17 come in contact with the respective terminals (not shown) formed under the rear part 42b and over the front part 42a, while the upper and lower adhesive regions 3 on both sides of the collector electrode 17 adhere to the respective terminals (not shown) formed under the rear part 42b and over the front part 42a.

Each of the collector electrodes 17 electrically connects the photoelectric conversion portions 42 of the mutually adjacent solar cells 19, thereby connecting the solar cells 19 arranged in juxtaposition in the front-rear direction in series.

Note that the collector electrodes 17 connecting the frontmost solar cell 19 are connected to the retrieval portion 21 (see FIG. 5), and the solar cell 19 and the collector electrodes 17 are protected by the protective portion 23 (indicated by the imaginary line of FIG. 21), though not shown in FIGS. 19 and 20.

With the collector electrodes 17 each formed of the conductive adhesive tape 1 shown in FIG. 18, it is also possible to connect the solar cells 19 each using the crystal-silicon-based solar cell element as the photoelectric conversion portions 42.

Note that the conductive adhesive tape 1 shown in FIG. 16 can also be used as the collector electrode 17 to connect the solar cells 19 shown in FIG. 21. In that case, as shown by the imaginary line of FIG. 17(d), the exfoliate sheet 39 formed under the adhesive portions 5 and the conductive portions 4 is stripped together with the adhesive layer 34.

In the conductive adhesive tapes 1 shown in FIGS. 1,9, 10, and 18, the adhesive portions 5 fill at least the upper recessed portions 11. Therefore, with the conductive adhesive tapes 1 described above, it is possible to support the adhesive portions 5 with the upper recessed portions 11.

As a result, compared with the conductive adhesive tapes 1 shown in FIGS. 14 and 16 in which the adhesive portions 5 do not fill the upper recessed portions 11 and both the upper and lower surfaces of the adhesive portions 5 are exposed, the conductive adhesive tapes 1 described above can be improved in mechanical strength.

Note that, in the description given above, the conductive adhesive member of the present invention is described as the conductive adhesive tape 1, but the conductive adhesive member of the present invention can also be used as, e.g., a conductive adhesive sheet or a conductive adhesive film.

Also in the description given above, the conductive adhesive tape 1 is used as the collector electrode 17 in the solar cell module 18, but the use application thereof is not particularly limited. For example, the conductive adhesive tape 1 can also be used for connection between the connection terminals of various electrical equipment except for the solar cell module 18.

### EXAMPLES

While in the following, the present invention will be described more specifically with reference to Example and Comparative Example, the present invention is not limited to any of them.

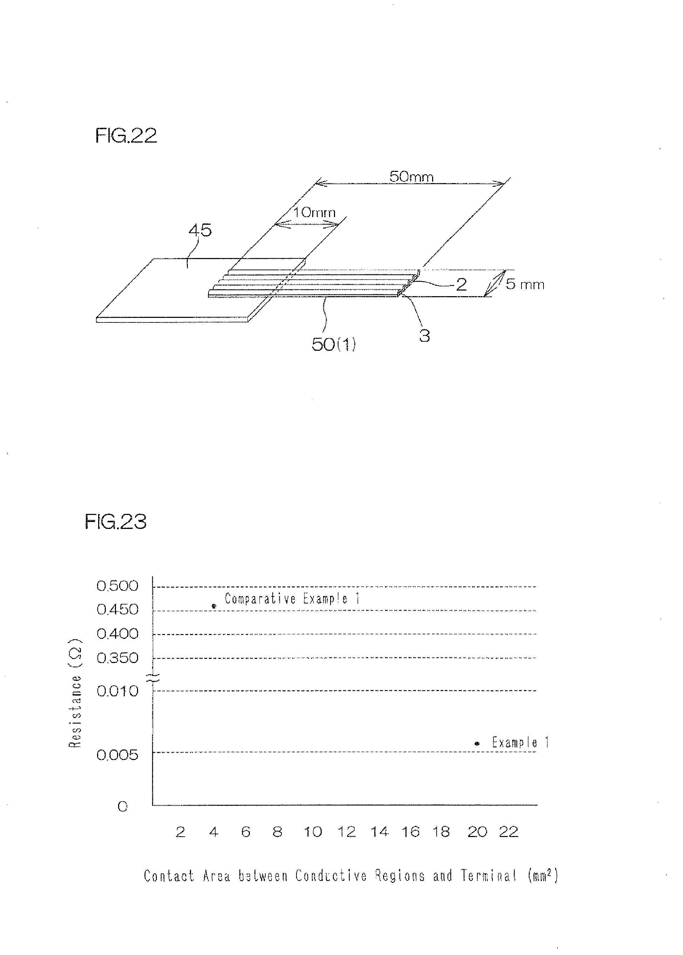

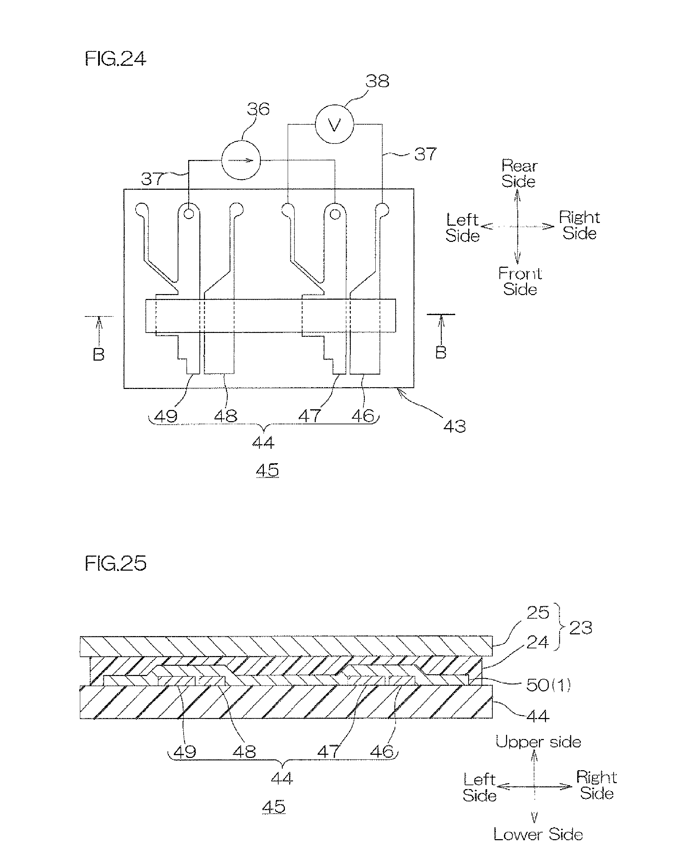

Note that FIG. 22 shows a perspective view illustrating a state of connection between a specimen and a terminal which are used for the evaluation (contact resistance test) of Examples. FIG. 23 is a graph showing a relationship between a resistance and a contact area between conductive regions and the terminal in the contact resistance test. FIG 24 shows a plan view of a sample for evaluation used in the evaluation (durability test) of Examples. FIG. 25 shows a front cross-sectional view along the line B-B of the sample for the evaluation of Examples shown FIG. 24.

### (Production of Conductive Adhesive Tape)

### Example 1

An elongated conductive plate made of copper and having a width (length in the lateral direction) of 250 mm and a thickness (T1) of 35 µm was prepared (see FIG. 2(a)).

Then, low-melting-point metal layers made of a tin-bismuth alloy (having a melting point of 139 °C) and having a thickness (T2) of 10 µm were formed by electrolytic plating on the upper surface and lower surface of the conductive plate (see FIG. 2(b)).

Then, the conductive plate formed with the low-melting point metal layers was subjected to bending using the roll mold described above to form a conductive portion having an S-shaped corrugated cross-sectional shape (see FIGS. 2(c) and 3).

In the conductive portion, the length (L1) between the upper surface of each of the top portions and the upper surface of the corresponding bottom portion was 35 µm, and the pitches (L2 and L3) were 1.0 mm.

Thereafter, an epoxy adhesive containing 100 parts by mass of an epoxy resin (bisphenol A type epoxy resin having an epoxy equivalent of 600 to 700 g/equiv.), 4 parts by mass of a curing agent (phenol compound), and 1 part by mass of a curing accelerator (imidazole compound) was coated onto the conductive portion by a blade coater method using the blade (squeegee) made of an elastomer resin mentioned above, and then dried. Subsequently, by heating to 40 to 60 °C, the epoxy adhesive was brought into a stage B state (semi-cured state) to form the adhesive portion (see FIGS. 2(d) and 4).

In this manner, a conductive adhesive tape including adhesive regions each having a width of 0.6 mm (W2) and conductive regions each having a width of 0.4 mm (W1) was obtained (see FIG. 1).

### Comparative Example 1

A conductive adhesive tape was produced in accordance with the description in Example 2 of Japanese Examined Patent Publication No. Sho 47-51798.

That is, the conductive adhesive tape was obtained by the same process as performed in Example 1 except that dotted protruding portions when viewed in plan view were formed in the fabrication of a conductive plate and that a knife coater method using a metallic knife was used in the coating of an epoxy adhesive.

In the obtained conductive adhesive tape, the adhesive portions were formed also on the upper surfaces of the protruding portions of the conductive portion, and conductive regions were not formed.

### (Evaluation)

### 1. Contact Resistance Test (JIS C2526-1994)

Each of the conductive adhesive tapes 1 obtained in Example 1 and Comparative Example 1 was cut into a specimen 50 having a length (length in the front-rear direction) of 50 mm and a width (length in the lateral direction) of 5 mm, as shown in FIG. 22, and the obtained specimen was subjected to a contact resistance test according to JIS C2526-1994 (four-terminal method).

In Example 1, the conductive regions 2 and the adhesive regions 3 of the specimen 50 were brought into contact with a terminal 45 first. Then, by performing thermo compression at 150 °C under 2 MPa for five minutes, the specimen 50 and the terminal 45 were connected and bonded to each other.

On the other hand, in Comparative Example 1, the adhesive regions were brought into contact with the terminal. Then, by performing thermocompression at 150 °C under 2 MPa for five minutes, the specimen 50 and the terminal 45 were joined to each other.

The result of the test is shown in FIG. 23

Note that, as shown in FIG. 22, the contact area between the specimen 50 and the terminal 45 was 50 mm² in each of Example 1 and Comparative Example 1. By regarding the contact area between the conductive regions 2 and the terminal 45 of Example 1 as the exposed area of the conductive regions 2, the contact area was calculated using an optical microscopic image. The result of the calculation is shown in FIG. 23.

On the other hand, in Comparative Example 1, during the thermocompression described above, the protruding portions were partially exposed as the conductive regions from the adhesive regions. By regarding the contact area between such conductive regions and the terminal as the area of the conductive regions exposed at the surface after stripping, the contact area was calculated using an optical microscopic image. The result of the calculation is shown in FIG. 23.

### 2. Durability Test

As shown in FIGS. 24 and 25, a terminal substrate 45 for evaluation was prepared.

The terminal substrate 45 included a substrate 43 made of a glass-epoxy resin and terminals 44 formed thereon into a predetermined pattern. The four terminals 44 were provided to be spaced apart from each other in the lateral direction. Each of the terminals 44 (first terminal 46, second terminal 47, third terminal 48, and fourth terminal 49) extended in the front-rear direction. Note that the first, second, third, and fourth terminals 46, 47, 48, and 49 were arranged in succession from right to left.

Then, the front end portion of each of the terminals 44 was connected to the specimen 50 of each of Example 1 and Comparative Example 1 produced in "1. Contact Resistance Test" described above. Note that the connection was performed under the same conditions as used in "1. Contact Resistance Test" described above.

In addition, the rear end portions of the second and fourth terminals 47 and 49 were connected to a constant current power source 36 via wires 37, and the rear end portions of the first and second terminals 46 and 47 were connected to a potentiometer 38 via the wires 37 to form an electric circuit.

In this manner, samples for evaluation were produced.

Subsequently, under durability conditions (1 to 4) shown in Table 1, a current of 2A was allowed to flow in the electric circuit to perform a durability test on the samples for evaluation.

**Table 1**

| No. | Durability Conditions | |
|---|---|---|
| | Temperature (Humidity) | Time (Number of cycles) |
| 1 | 85 to 90 °C | 1000 Hours |
| 2 | -40 °C | 1000 Hours |
| 3 | 85 °C, 85%RH | 1000 Hours |
| 4 | -40°C ↔ 85°C^{*1} | 200 Cycles |

| | | |
|---|---|---|
| * 1: Heat Cycle Test Which Repeatedly Alternates Temperature between -40°C and 85°C | | |

As a result, in Example 1, it was confirmed that, under any of the durability conditions 1 to 4, the resistance did not increase.

On the other hand, in Comparative Example 1, it was confirmed that, under each of the durability conditions 1 to 4, the resistance increased.

## Claims

1. A conductive adhesive member, comprising:
a conductive region continuously exposed along one direction; and
an adhesive region exposed along the conductive region.

2. The conductive adhesive member according to claim 1, wherein the adhesive region is disposed on each of both sides of the conductive region.

3. The conductive adhesive member according to claim 1 or 2, wherein the conductive region includes a plurality of stripe portions.

4. The conductive adhesive member according to claim 1, 2 or 3, further comprising:a conductive portion including a recessed portion; and
an adhesive portion filling in the recessed portion, wherein
the adhesive region is the adhesive portion, and
the conductive region is the conductive portion exposed from the adhesive portion.

5. The conductive adhesive member according to any of claims 1 to 4, wherein the conductive region includes a low-melting-point metal layer formed on a surface thereof.

6. The conductive adhesive member according to any of claims 1 to 5, wherein the conductive adhesive member is used as a collector electrode for collecting carriers generated in a solar cell.

7. A solar cell module, comprising:
a solar cell; and
a conductive adhesive member used as a collector electrode for collecting carriers
generated in the solar cell, wherein
the conductive adhesive member includes:
a conductive region continuously exposed along one direction; and
an adhesive region exposed along the conductive region.
